# EUROPEAN PATENT SPECIFICATION

(11) **EP 2 555 359 B1**
(45) Date of publication and mention of the grant of the patent: **07.11.2018**
(21) Application number: 12179281.6
(22) Date of filing: 03.08.2012
(51) Int. Cl.: H02B 5/02

(54) **Housing for mounting an electrical device**
Gehäuse zum Montieren einer elektrischen Vorrichtung
Logement pour monter un dispositif électrique

(30) Priority: 05.08.2011 US 201113198872
(43) Date of publication of application: 06.02.2013
(73) Proprietor: Thomas & Betts International, Inc., Wilmington, Delaware 19809 (US)
(72) Inventor: Fong, Robert, Bethlehem, PA Pennsylvania 18015 (US); Gardner, Daniel L., Stewartsville, NJ New Jersey 08886 (US)
(74) Representative: Howick, Nicholas Keith

(56) References cited:
- DE-A1- 3 737 102
- DE-B- 1 071 802
- GB-A- 591 557
- US-A- 1 190 971
- US-A- 1 647 069
- US-A- 1 806 560
- US-A- 2 086 355
- US-A- 2 263 620
- US-A- 2 910 315
- US-A- 3 765 636

## Description

### Field of the Invention

In general, the present invention relates to a rotatable lower housing for a high voltage electrical circuit or other high voltage electrical device. More particularly, the present invention relates to a cylindrically-shaped lower housing which is rotatable, a bracket for mounting the lower housing onto a support structure, and a surrounding element which allows the lower housing to be rotatable with respect to the bracket.

### Background

In the utilities industry, often times high voltage electrical equipment or other high voltage electrical devices are mounted onto utility structures, such as transmission or distribution poles, prior to electrical cables, wires or connecting electrical equipment being connected to the high voltage electrical circuits or devices. When utility installers connect the electrical cables or wires to the electrical equipment, it is often desirable for the electrical equipment to be in proper alignment with the connecting electrical equipment, as such electrical circuits can be quite heavy and cumbersome to manipulate, often requiring the assistance of a lift truck or other heavy equipment.
DE 10 71 802 B discloses an oil filled multipolar cable termination housing and the holder for attaching it.
GB 591 557 A discloses an improved mounting bracket for transformers which are supported by a shoulder.
US 2 263 620 A discloses a housing for lightning arresters which are formed of sectional glass housings and an appropriate mounting bracket for such.

### Summary of the Invention

The present invention provides a housing according to claim 1. Optional features of the housing are specified in the sub claims.
As used herein the term "rotatable" is considered to be any rotation of at least 5 degrees of the lower housing.

### Brief Description of the Drawings

FIG. 1 is a plan view of a rotatable lower housing and a one-piece surrounding mounting bracket for a high voltage electrical device not according to the present invention taken along section B-B of FIG. 2.
FIG. 2 is cross-sectional elevation view of a rotatable lower housing and a one- piece surrounding mounting bracket for a high voltage electrical device not according to the present invention taken along section C-C of FIG. 1.
FIG. 3 is a front perspective view of a rotatable lower housing and a one-piece surrounding mounting bracket for a high voltage electrical device not according to the present invention.
FIG. 4 is a plan view of a rotatable lower housing with upper and lower bands connected to a bracket for a high voltage electrical device not according to the present invention taken along section B-B of FIG. 5.
FIG. 5 is a side elevation view of a rotatable lower housing with upper and lower bands connected to a bracket for a high voltage electrical device not according to the present invention.
FIG. 6 is a front perspective view of a rotatable lower housing with upper and lower bands connected to a bracket for a high voltage electrical device not according to the present invention.
FIG. 7 is a plan view of a rotatable lower housing with an integral surrounding I-slot for a high voltage electrical device of the present invention taken along section B-B of FIG. 8.
FIG. 8 is cross-sectional elevation view of a rotatable lower housing with an integral surrounding I-slot for a high voltage electrical device of the present invention taken along section A-A of FIG. 7.
FIG. 9 is a front perspective view of a rotatable lower housing with an integral surrounding I-slot for a high voltage electrical device of the present invention.

### Detailed Description of the Preferred Embodiment(s)

The above and other features, aspects and advantages of the present invention will now be discussed in the following detailed description of preferred embodiments and appended claims, which are to be considered in conjunction with the accompanying drawings in which identical reference characters designate like elements throughout the views.

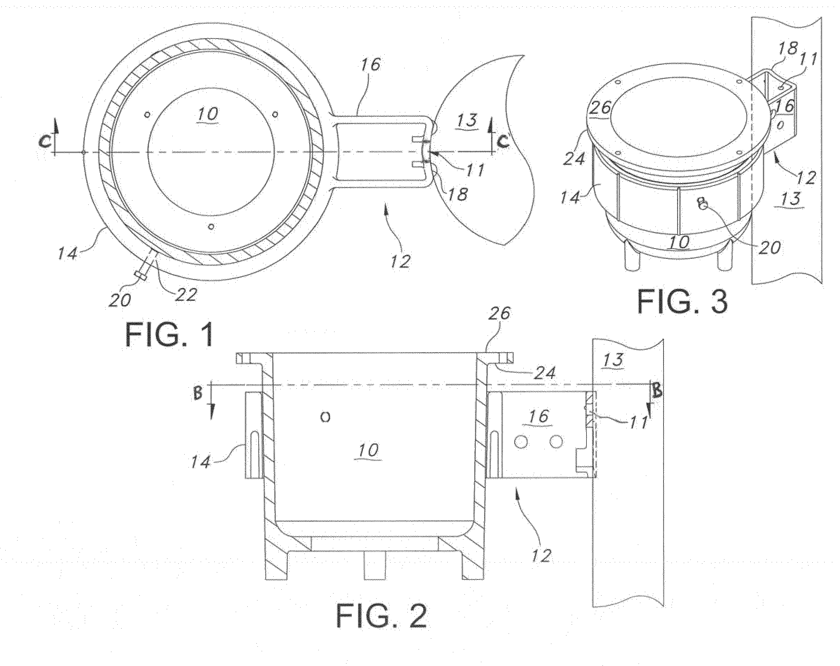

Shown in FIG. 1 is a plan view of a first example not according to the present invention, which is a rotatable lower housing 10 for a single phase recloser of a high voltage electrical circuit or another high voltage electrical device. The lower housing may be made of a corrosion-resistant metal, such as stainless steel, or a high-strength plastic. The housing may also be painted with a UV and/or corrosion-resistant paint for further protection from the environment. FIG. 1 shows the cylindrical rotatable lower housing 10 being completely surrounded by a one-piece surrounding mounting bracket 12. The one-piece surrounding mounting bracket 12 comprises a ring 14 which completely surrounds the lower housing 10. At least two parallel side walls 16 are shown protruding from the ring 14, and a rear wall 18 is shown which connects the two side walls 16 and is perpendicular to the side walls 16. The rear wall 18 allows the one piece surrounding mounting bracket 12 to be mounted to a support structure 13, such as a utility or distribution pole, by hardware such as bolts or screws which are received by at least one aperture 11 in the rear wall 18 to attach the rear wall 18 to the support structure 13. For ease of installation and assembly of the one-piece surrounding mounting bracket 12, it may be a precast component which is made of a metallic or high-strength plastic material. It may also be formed of a weather resistant steel such as stainless steel or galvanized steel.

Also shown in FIG. 1 is an anti-rotation fastener 20. The anti-rotation fastener 20 is received through an aperture 22 that is contained within the ring 14. The anti- rotation fastener 20 may, for example, be a screw which can be loosened or tightened within the aperture 22 that is contained in the ring 14 such that when tightened, the screw contacts the rotatable lower housing 10, thereby preventing rotation of the housing 10. Likewise, the anti-rotation fastener 20 can be loosened such that it does not contact the lower housing 10, thereby allowing the lower housing 10 to freely rotate within the ring 14 of the one-piece surrounding mounting bracket 12. In FIG. 1, only one anti-rotation fastener 20 is shown, however, it is understood that more than one anti-rotation fastener may be used at multiple locations on the ring 14 of the surrounding mounting bracket 12.

Shown in FIG. 2 is a cross-sectional elevation view of the first example not according to the present invention. In FIG. 2, a radial flange 26 of the rotatable lower housing 10 is shown, and a lip 24 of the radial flange 26 is also shown. The lip 24 and the radial flange 26 are integrally formed with the rotatable lower housing 10. The presence of the lip 24 prevents downward vertical movement of the rotatable lower housing 10 through the one-piece surrounding mounting bracket 12 when the lip 24 is in contact with the one-piece surrounding mounting bracket 12. FIG. 3 shows a front perspective view of the first preferred embodiment of the present invention and again shows each of the elements previously discussed in FIGS. 1 and 2.

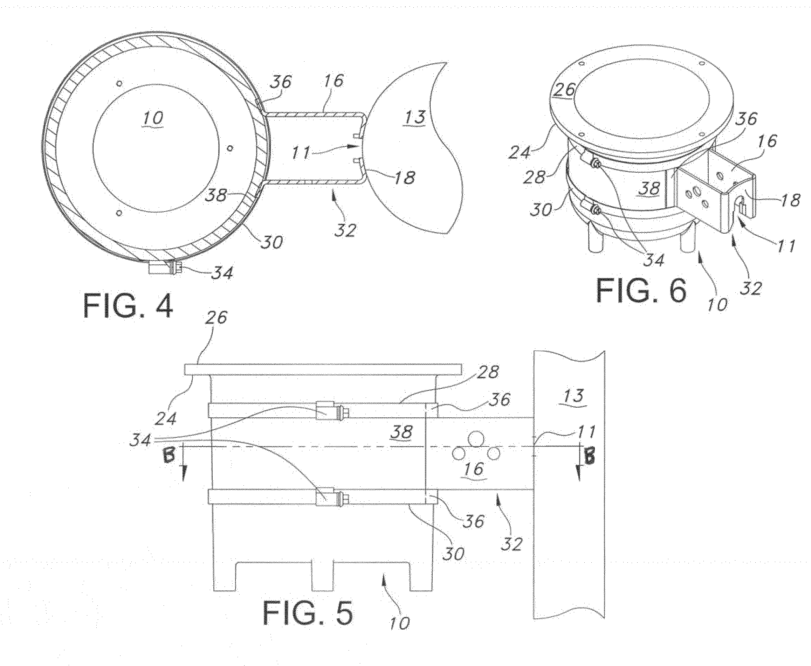

Shown in FIGS. 4-6 are varying views of a second example not according to the present invention. FIG. 5 is a side elevation view of a cylindrical rotatable lower housing 10 with upper and lower bands 28 and 30 which completely surround the lower housing 10. The bands 28 and 30 may be made of a corrosion resistant metallic material or a high-strength plastic. Each of the bands has a band adjustment mechanism 34 located on the respective bands. The band adjustment mechanism 34 allows for adjustment of tension within the bands 28 and 30 such that the bands may be tightened or loosened around the lower housing 10. A bracket 32, comprising two parallel side walls 16 and a rear wall 18 which is perpendicular to the side walls 16, is affixed to the bands 28 and 30. The rear wall 18 allows the bracket 32 to be mounted to a support structure 13, such as a utility or distribution pole, by hardware such as bolts or screws which are received by at least one aperture 11 in the rear wall 18 to attach the rear wall 18 to the support structure 13. Like the bands 28 and 30, the bracket 32 may be made of a corrosion resistant metallic material or a high-strength plastic.

In FIGS. 4 and 5, the bracket 32 is shown to be affixed to the bands 28 and 30 by tabs 36 which are connected to and protrude from the side walls 16 of the bracket 32. The tabs 36 non-fixedly abut a surface 38 of the lower housing 10 so that the housing 10 may freely rotate within the bands 28 and 30. The tabs 36 may be affixed to the bracket 32 and the bands 28 and 30 by welding, such that the tabs 36, bracket 32 and bands 28 and 30 are a one-piece assembly. It is understood that other means, such as a curved plate affixed to the bands 28 and 30 and the bracket 32, and non-fixedly abutting the surface 38 of the lower housing 10 so that the housing 10 may freely rotate within the bands 28 and 30, may be used in place of the tabs 36.

Shown in FIG. 5 is a radial flange 26 of the rotatable lower housing 10 and a lip 24 of the radial flange 26, as is also shown and previously described in FIG. 2. The lip 24 serves the same purpose as mentioned previously, preventing downward vertical movement of the rotatable lower housing 10 through the bands 28 and 30 when the lip 24 is in contact with the top band 28 and the bracket 32. FIG. 6 shows a front perspective view of the second embodiment not according to the present invention and again shows each of the elements previously discussed in FIGS. 4 and 5.

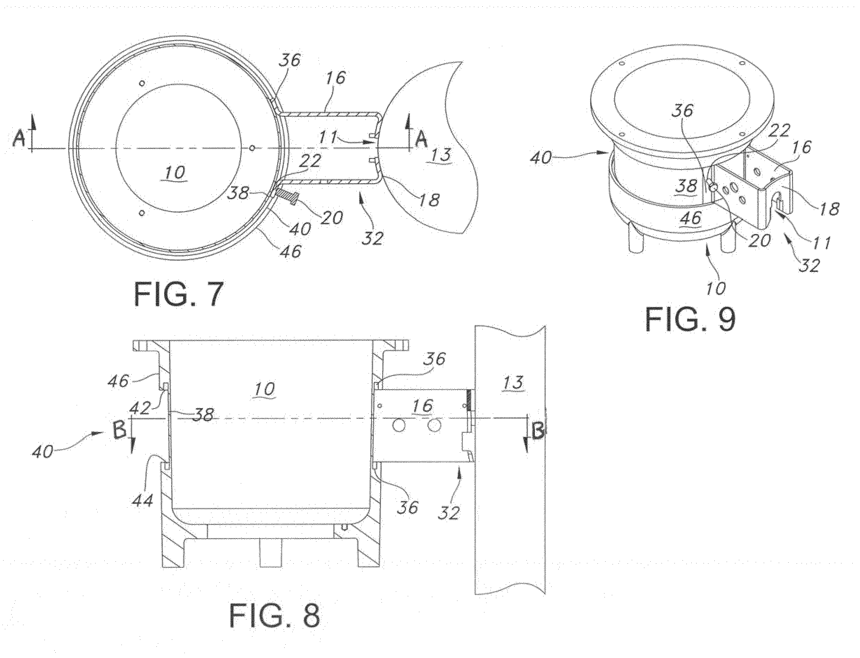

FIGS. 7-9 show varying views of an embodiment of the present invention of a rotatable lower housing 10 for a single phase recloser. In this third embodiment, an integral surrounding recessed I-slot 40 allows a cylindrical lower housing 10 to be rotated with respect to a stationary bracket 32, made of either a corrosion resistant metallic material or a high-strength plastic material, which is mounted onto a support structure 13, such as a utility or distribution pole, by a rear wall 18 of the bracket 32 which contains at least one aperture 11 for receiving hardware such as bolts or screws for mounting the bracket. FIG. 7 shows a cross-sectional view of the rotatable lower housing 10. In this figure, the stationary bracket 32 is shown, comprising two side walls 16 and the rear wall 18. Tabs 36 are also shown as part of the bracket 32, which are protruding from the side walls 16 of the bracket 32 and slidably seated within the integral surrounding recessed I-slot 40. The tabs 36 are shown non-fixedly contacting a surface 38 of the rotatable lower housing 10. It is understood that other means, such as a curved plate seated within the integral surrounding recessed I-slot 40 and affixed to the side walls 16 of the bracket 32 and non-fixedly abutting the surface 38 of the lower housing 10 so that the housing 10 may freely rotate with respect to the bracket 32, may be used in place of the tabs 36.

An anti-rotation fastener 20 is also shown in FIG. 7. The anti-rotation fastener is received through an aperture 22 which is contained within at least one tab 36 of the bracket 32. As explained previously in FIG. 1, the anti-rotation fastener 20 may, for example, be a screw which can be loosened or tightened within the aperture 22 that is contained within at least one tab 36 of the bracket 32 such that when tightened, the screw contacts the surface 38 of the rotatable lower housing 10, thereby preventing rotation of the lower housing 10. Likewise, the anti-rotation fastener 20 can be loosened such that it does not contact the surface 38 of the lower housing 10, thereby allowing the lower housing 10 to freely rotate with respect to the stationary bracket 32 which is mounted to a support structure 13, such as a utility or distribution pole. In FIG. 7, only one anti-rotation fastener 20 is shown, however, it is understood that more than one anti-rotation fastener may be used.

FIG. 8 shows a cross-sectional elevation view of the previously discussed figure. In FIG. 8, it can be seen that the integral surrounding recessed I-slot 40 contains an upper channel 42 and a lower channel 44 which are formed from a recess between the surface 38 of the lower housing 10 and an outer wall 46 of the lower housing 10. FIG. 8 also shows that the aforementioned tabs 36 of the bracket 32 are slidably seated within the upper channel 42 and the lower channel 44 of the I-slot 40 and non-fixedly abut the surface 38 of the lower housing 10.

In FIG. 9 a front perspective view of the embodiments discussed in FIGS. 7 and 8 is shown. FIG. 9 again shows the anti-rotation fastener 20 being received through the aperture 22 contained within the tab 36 of the bracket 32, thereby allowing the lower housing 10 to be rotated with respect to the bracket 32 when the anti-rotation fastener 20 is loosened, or keeping the lower housing 10 locked in place when the anti-rotation fastener 20 is tightened and contacting the surface 38 of the lower housing 10.

Although the invention has been described in detail above, it is expressly understood that it will be apparent to persons skilled in the relevant art that the invention may be modified without departing from the scope of the invention as defined by the appended claims. Various changes of form, design, or arrangement may be made to the invention without departing from the scope of the invention as defined by the appended claims. Therefore, the above mentioned description is to be considered exemplary, rather than limiting, and the true scope of the invention is that defined in the following claims.

## Claims

1. A housing for mounting an electrical device onto a support structure, the housing comprising:
a lower housing (10) having an integral recessed I-slot (40) completely surrounding the lower housing, the I-slot having an upper channel (42) and a lower channel (44) formed between a surface (38) and an outer wall (46) of the lower housing;
a bracket (32) for mounting the lower housing onto the support structure (13), the bracket being slidably seated within the upper channel and the lower channel of the I-slot;
wherein the lower housing is rotatable with respect to the bracket; and
wherein the bracket comprises at least two parallel side walls (16) and a rear wall (18) which is perpendicular to the side walls and which connects the side walls and is configured to fixedly abut the support structure.

2. The housing of claim 1, wherein the bracket is slidably seated within the upper channel and the lower channel of the I-slot by tabs (36) which connect to and protrude from the parallel side walls of the bracket and which are opposite from the rear wall of the bracket and wherein the tabs non-fixedly abut a surface of the rotatable lower housing.

3. The housing of claim 2, wherein at least one of the tabs contains an aperture (22) for receiving a fastener (20) for selectively preventing the lower housing from rotating with respect to the bracket.

## Patentansprüche

1. Gehäuse zum Montieren einer elektrischen Vorrichtung auf eine Stützstruktur, wobei das Gehäuse Folgendes umfasst:
ein unteres Gehäuse (10) mit einem integralen I-Schlitz (40), der das untere Gehäuse vollständig umgibt, wobei der I-Schlitz einen oberen Kanal (42) und einen unteren Kanal (44), die zwischen einer Fläche (38) und einer Außenwand (46) des unteren Gehäuses ausgebildet sind, aufweist;
eine Halterung (32) zum Montieren des unteren Gehäuses auf die Stützstruktur (13), wobei die Halterung gleitend innerhalb des oberen Kanals und des unteren Kanals des I-Schlitzes sitzt;
wobei das untere Gehäuse in Bezug auf die Halterung drehbar ist und
wobei die Halterung zumindest zwei parallele Seitenwände (16) und eine Rückwand (18) umfasst, die senkrecht zu den Seitenwänden ist und die Seitenwände verbindet und dazu ausgelegt ist, fest an der Stützstruktur anzuliegen.

2. Gehäuse nach Anspruch 1, wobei die Halterung durch Laschen (36), die mit den parallelen Seitenwänden der Halterung verbunden sind und aus diesen hervorragen und die der Rückwand der Halterung gegenüberliegen, gleitend innerhalb des oberen Kanals und des unteren Kanals des I-Schlitzes sitzt und wobei die Laschen nicht fest an einer Fläche des drehbaren unteren Gehäuses anliegen.

3. Gehäuse nach Anspruch 2, wobei zumindest eine der Laschen eine Öffnung (22) zum Aufnehmen eines Befestigungsmittels (20) umfasst, um selektiv zu verhindern, dass sich das untere Gehäuse in Bezug auf die Halterung dreht.

## Revendications

1. Logement pour monter un dispositif électrique sur une structure de support, le logement comprenant :
un logement inférieur (10) ayant une fente en I encastrée intégrée (40) entourant complètement le logement inférieur, la fente en I ayant un canal supérieur (42) et un canal inférieur (44) formés entre une surface (38) et une paroi externe (46) du logement inférieur ;
un support (32) pour monter le logement inférieur sur la structure de support (13),
le support étant placé de manière coulissante à l'intérieur du canal supérieur et du canal inférieur de la fente en I ;
le logement inférieur pouvant tourner par rapport au support ; et
le support comprenant au moins deux parois latérales parallèles (16) et une paroi arrière (18) qui est perpendiculaire aux parois latérales et qui relie les parois latérales et est conçue pour venir en butée de manière fixe contre la structure de support.

2. Logement selon la revendication 1, le support étant disposé de manière coulissante dans le canal supérieur et le canal inférieur de la fente en I par des languettes (36) qui sont reliées aux parois latérales parallèles du support, et en font saillie, et qui sont opposées à la paroi arrière du support et les languettes venant en butée de manière non fixe contre une surface du logement inférieur rotatif.

3. Logement selon la revendication 2, au moins l'une des languettes contenant une ouverture (22) pour recevoir un élément de fixation (20) pour empêcher sélectivement le logement inférieur de tourner par rapport au support.
